# EUROPÄISCHE PATENTANMELDUNG

(11) **EP 4 016 264 A1**
(43) Veröffentlichungstag der Anmeldung: **22.06.2022**
(21) Anmeldenummer: 21209260.5
(22) Anmeldetag: 19.11.2021
(51) Int. Cl.: G06F 3/044, H03K 17/96

(54) **ANORDNUNG ZUR ORTSAUFLÖSENDEN PROJIZIERT-KAPAZITIVEN BERÜHRDETEKTION MIT LICHTDURCHLÄSSIGEM SUBSTRAT**

(30) Priorität: 21.12.2020 DE 102020134394
(71) Anmelder: Marquardt GmbH, 78604 Rietheim-Weilheim (DE)
(72) Erfinder: LEIBER, Christoph, 78194 Immendingen (DE); SCHÄFER, Benjamin, 72186 Empfingen (DE); HERMANN, Jochen, 72355 Schömberg (DE); STOPPER, Guido, 72469 Meßstetten (DE)
(74) Vertreter: Staeger & Sperling Partnerschaftsgesellschaft mbB

(57) **Zusammenfassung**

Die Erfindung betrifft eine Anordnung zur ortsauflösenden projiziert-kapazitiven Berührdetektion aufweisend ein elektrisch isolierendes Substrat (5), mit mehreren auf dem Substrat nebeneinander angeordneten elektrisch leitenden Flächen erster Gattung (1) und zweiter Gattung (2), wobei die Flächen innerhalb einer Gattung regelmäßig eine gleichförmige Flächenausbildung aufweisen, und wobei die Flächen erster Gattung (1) untereinander elektrisch verbunden sind, um mehrere Senderelektroden auszubilden und die Flächen zweiter Gattung (2) elektrisch verbunden sind, um mehrere Empfangselektroden auszubilden, und im Wesentlichen ein regelmäßiges Muster aufgrund ihrer gattungsgemäßen regelkonformen Flächenausbildung und Platzierung ausbildend angeordnet sind, wobei in dem Substrat (5) ein Bereich (4) ausgebildet ist, wobei die Empfangselektroden spaltenweise und die Sendeelektroden reihenweise miteinander verbunden sind, dass die Flächen erster Gattung (1) und die Flächen zweiter Gattung (2) alternierend angeordnet sind, dass die Fläche der einen Gattung (6) von mehreren Flächen der anderen Gattung (7) jeweils einen Minimalabstand (3) einhaltend umgeben ist, und dass wenigstens eine an den Bereich (4) angrenzende erste Fläche (1b, 2a) der ersten Gattung (1) oder zweiten Gattung (2) vorgesehen ist, die bezüglich ihrer gattungsgemäßen Flächenausbildung und/oder Platzierung nicht regelkonform so ausgestaltet ist, dass der vorgegebene Minimalabstand (3) zu jeweils wenigstens zwei nächstbenachbarten Flächen (1a, 1a') der anderen Gattung erreicht wird, dadurch gekennzeichnet, dass ein Bereich 4a oberhalb einem lichtdurchlässigen Substrat 5 oder einem Bereich im Substrat 5 angeordnet ist, welches lichtdurchlässig ist.

## Beschreibung

Die Erfindung betrifft im Allgemeinen eine Anordnung zur ortsauflösenden projiziert-kapazitiven Berührdetektion, insbesondere ein Touchpad in projiziert-kapazitiver Technologie. Die projiziert-kapazitive Technologie (Projected Capacitive Technology, pcap touch) entwickelte sich rasend schnell zu einer der wichtigsten Touch-Technologien für immer mehr Anwendungen von Consumer-Geräten bis hin zu kommerziellen Applikationen im Automobilbereich. Da touchfähige Geräte von immer mehr Nutzern verwendet werden, geben sich Verbraucher und Experten längst nicht mehr mit einfacher Single-Touch- Funktionalität zufrieden und erwarten stattdessen berührungsaktive Anwendungen mit Multi- Touch- und Multi-User-Fähigkeiten.

Die projiziert-kapazitive Technologie erkennt Berührungen, indem sie die elektrische Kapazität an jeder adressierbaren Elektrode misst. Wenn sich ein Finger oder leitfähiger Stift einer Elektrode nähert, wird ihr elektromagnetisches Feld gestört und ihre elektrische Kapazität verändert. Diese Veränderung kann von der Elektronik gemessen und in X,Y-Koordinaten umgewandelt werden, die dann vom System zur Berührungserkennung genutzt werden können. Bei den Methoden zur Berührungserkennung werden zwei Haupttypen unterschieden, die als Self Capacitance (Eigenkapazität) und Mutual Capacitance (Gegenkapazität) bezeichnet werden.

Die erste Berührungserkennungsmethode beruht auf der Eigenkapazität. Dabei misst die Elektronik den an jeder Elektrode anliegenden Strom gegenüber dem Erdungsniveau. Für die Berührungserkennung gibt es zwei Möglichkeiten, wobei die Elektroden entweder als Multi-Pad oder in Zeilen und Spalten angeordnet sein können. Bei der Multi-Pad-Konstruktion ist jede Elektrode bzw. jedes "Pad" einzeln von der Elektronik adressierbar, weshalb eine individuelle Verbindung zwischen Elektrode und Controller erforderlich ist. Aus diesem Grund ist bei Self-Capacitance-Systemen mit Multi-Pad eine Multi-Touch-Steuerung zwar möglich, da aber jedes Pad einzeln adressiert werden muss, ist die Umsetzung für Touchpads mit mehr als 3,5 Zoll Diagonale sehr schwierig. Bei der Anordnung in Zeilen und Spalten stellt jede Zeile und jede Spalte eine Elektrode dar und wird einzeln von der Auswerteinheit adressiert. Obwohl der Schnittpunkt einer Zeile und einer Spalte ein eindeutiges Koordinatenpaar darstellt, kann die Auswerteinheit nur einzelne Elektroden, nicht aber jeden einzelnen Schnittpunkt erfassen. Daher sind diese Systeme auf Single- und Dual- Touch-Erkennung beschränkt, wobei sogenannte "Ghost Points" problematisch sein können. Diese sind das Ergebnis imaginärer oder falscher Schnittpunkte an Stellen, die nicht dem Berührungspunkt entsprechen.

Unter Mutual Capacitance (Gegenkapazität) versteht man die beabsichtigte oder unbeabsichtigte elektrische Kapazität zwischen zweigeladenen Gegenständen. Bei projiziert-kapazitiven Touchpads (pcap touch) wird absichtlich eine Gegenkapazität zwischen den sich im Umfeld der einzelnen Schnittpunkte befindlichen Elementen von Zeilen und Spalten aufgebaut. Auf diese Weise kann die Systemelektronik jeden Knoten (Schnittpunkt) individuell messen und so mit einem einzigen Scandurchlauf mehrere Berührungen auf dem Touchpad erfassen.

Berührt man das Touchpad in der Nähe eines Schnittpunkts, wird ein Teil der Gegenkapazität zwischen Zeile und Spalte an den Fingergekoppelt und die von der Auswerteinheit gemessene elektrische Kapazität des Schnittpunkts reduziert. Diese reduzierte elektrische Kapazität überschreitet die von der Auswerteinheit festgelegte "Berührungsschwelle" und signalisiert dem System, dass eine Berührung stattgefunden hat.

Die zur Berührdetektion vorgesehene in Reihen und Spalten angeordnete Elektrodenstruktur ist in der Regel von einem alternierenden, strengregelmäßigen Muster von Elektrodenflächen, üblicherweise als "pads" und im Folgenden auch kurz als "Flächen" bezeichnet, geprägt. Die Dichte der Anordnung gibt das Auflösungsvermögen vor. Beispielsweise sind die Flächen rautenförmig, schneeflockenförmig, dreieckig oder rund, wobei sich die Form oder Außenumfang der Flächen der reihenweise verbundenen Elektroden von der Form oder Außenumfang der spaltenweise verbundenen Elektroden üblicherweise aber nicht zwingend unterscheidet. Lokale geometrische Abweichungen von dem regelmäßigen Muster sorgen üblicherweise für eine Störung des Auflösungsvermögens an der betreffenden lokalen Stelle und werden daher vermieden. Da die Elektrodenstruktur regelmäßig möglichst unmittelbar hinter einer die Berührfläche ausbildenden Schicht vorgesehen ist, werden die Elektrodenstruktur und ihr Substrat durchlaufende Durchbrüche für Befestigungsmittel oder hinterleuchtbare Orientierungshilfen oder Symbole, insbesondere bei einem nicht durchleuchtbarem Substrat, nur außerhalb der Berührfläche angeordnet, um das Auflösungsvermögen nicht zu beeinträchtigen. Damit ist die Gestaltungsvielfalt eingeschränkt, der erforderliche Bauraum wird vergrößert, Symbole bzw. Orientierungshilfen sind hinsichtlich der bedienkonzeptionellen Auslegung nicht optimal platziert.

Die US 2015/075960 A1 und die DE 10 2010 045194 A1 offenbaren jeweils eine gattungsgemäße Anordnung zur ortsauflösenden projiziert-kapazitiven Berührdetektion, wobei aus letzterer eine Anordnung gemäß dem Oberbegriff des Anspruchs 1 bekannt ist.

Diesen Nachteil entdeckend, haben sich die Erfinder die Aufgabe gestellt, geometrische Abweichungen von dem streng regelmäßigen Muster, insbesondere Durchbrüche durch die Elektronenstruktur, zu kompensieren und so dennoch ein dem streng regelmäßigen Muster nahekommendes Auflösungsvermögen der Berührdetektion zu erreichen, um so eine bedienerfreundliche, platzsparende und übersichtliche Bedienfläche für die Verwendung in Kraftfahrzeugen zu schaffen.

Diese Aufgabe wird durch eine Anordnung gemäß Anspruch 1 gelöst. Vorteilhafte Ausgestaltungen der Anordnung sind jeweils Gegenstand der abhängigen Ansprüche. Es ist darauf hinzuweisen, dass die in den Patentansprüchen einzeln aufgeführten Merkmale in beliebiger, technologisch sinnvoller Weise miteinander kombiniert werden können und weiter Ausgestaltungen der Erfindung aufzeigen. Die Beschreibung, insbesondere im Zusammenhang mit den Figuren, charakterisiert und spezifiziert die Erfindung zusätzlich.

Die erfindungsgemäße Anordnung zur ortsauflösenden projiziert-kapazitiven Berührdetektion weist ein elektrisch isolierendes Substrat (im folgenden nur Substrat), mit mehreren auf dem Substrat nebeneinander angeordneten, elektrisch leitenden Flächen, beispielsweise metallische, erster und zweiter Gattung auf. Innerhalb einer Gattung weisen die Flächen eine regelmäßige gleichförmige Flächenausbildung auf, beispielsweise sind die Flächen rautenförmig, dreieckig, schneeflockenförmig oder rund. Insbesondere sind die geometrischen Formen der Flächen so ausgestaltet, dass die Dichte der Flächen, hinsichtlich des gewünschten Auflösungsvermögens der Berührdetektion optimiert wird. Flächen die eine der jeweiligen Gattung entsprechende regelmäßige gleichförmige Flächenausbildung aufweisen, bezeichnet man als gattungsgemäß.

Die Flächen erster Gattung sind bevorzugt reihenweise untereinander elektrisch verbunden, um mehrere Senderelektroden auszubilden. Die Flächen zweiter Gattung sind bevorzugt spaltenweise untereinander elektrisch verbunden, um mehrere Empfangselektroden auszubilden. Wobei die Bezeichnungen spaltenweise und reihenweise nur der funktionellen Unterscheidung der Flächengattung dienen und nicht hinsichtlich der räumlichen Ausrichtung einschränkend zu verstehen sind.

Die Flächen der ersten und zweiten Gattung sind gattungsweise alternierend auf dem Substrat angeordnet. Der Begriff alternierend ist dabei so zu verstehen, dass die, zu einer Fläche einer Gattung, räumlich nächstliegenden Flächen, Flächen der jeweils anderen Gattung und die übernächsten Flächen, Flächen der jeweils gleichen Gattung sind. Durch diese gattungsweise alternierende Anordnung wird ein im Wesentlichen regelmäßiges Muster ausgebildet, so dass die Fläche der einen Gattung von mehreren Flächen der anderen Gattung, jeweils einen Minimalabstand einhaltend, umgeben ist. Der Minimalabstand ist dabei als der minimalste Abstand zwischen der jeweiligen nächsten Längsseite der benachbarten Flächen erster und zweiter Gattung zu verstehen. Der Abstand ist gemäß einer Ausgestaltung über sich gegenüberliegende Flanken der nächstbenachbarten Flächen konstant gehalten. Als ein regelmäßiges Muster wird beispielsweise ein solches Muster angesehen, bei dem der Abstandzwischen den geometrischen Mittelpunkten der platzierten Flächen erster und zweiter Gattung über den Erstreckungsbereich des Musters gleich bleibt. Flächen die dem regelmäßigen Muster entsprechend angeordnet sind, sind regelkonform ausgebildet.

Der Kern der vorliegenden Erfindung besteht darin, dass das Substrat lichtdurchlässig ist oder zumindest lichtdurchlässige Bereich aufweist.

Erfindungsgemäß ist in dem elektrisch isolierendem Substrat ein Durchbruch ausgebildet, wobei wenigstens eine an den Durchbruch angrenzende erste Fläche der ersten oder zweiten Gattung vorgesehen ist, die bezüglich ihrer gattungsgemäßen Flächenausbildung und/oder gattungsgemäßen Positionierung nicht regelkonform ausgestaltet ist, wobei der vorgegebene Minimalabstand zu jeweils wenigstens zwei nächstbenachbarten Flächen der anderen Gattung erreicht wird. Als eine nicht gattungsgemäße regelkonforme Positionierung wird beispielsweise eine Anordnung angesehen, bei der der ansonsten im verbleibenden regelmäßigen Muster gattungsgemäß regelkonform übereinstimmende Abstand zwischen den Flächen betreffend diese Fläche nicht eingehalten wird. Als eine nicht gattungsgemäße regelkonforme Flächenausbildung wird beispielsweise eine wesentliche, gegebenenfalls ausschließliche Abweichung in dem der betreffenden Fläche von den gattungsgemäßen regelkonformen Flächen des verbleibenden, regelmäßigen Musters angesehen. So können beispielsweise Flächen der ersten und zweiten Gattung deformiert, d.h. in Spalten- und/oder Reihenrichtung gestreckt oder gestaucht sein, wobei sich die Deformation auf den Außenumfang der Fläche bezieht. Im Allgemeinen werden Abweichungen innerhalb von sonst bezüglich ihres Außenumfangs regelkonformen Flächen nicht als eine deformierte und damit nicht regelkonforme Flächenausbildung angesehen. In einer nicht regelkonformen Flächenausbildung kann zusätzlich auch die Positionierung der deformierten Fläche von der dem regelmäßigen Muster entsprechenden Position abweichen. Durch die nicht regelkonforme Anordnung der Flächen wird insbesondere erreicht, dass die betreffende Elektrode um den Durchbruch herumgeführt und damit die Sensitivität und zugehörige Ortsauflösung trotz des Durchbruchs erhalten bleibt. Dies hat die erfindungsgemäße Wirkung, dass trotz der nicht regelkonformen Flächenausbildung, das Auflösungsvermögen der Berührdetektion im Bereich des Durchbruches erhalten bzw. nahezu erhalten bleibt.

Gemäß einer bevorzugten Ausführungsform ist wenigstens eine der zwei zur nicht regelkonformen ersten Fläche nächstbenachbarten Flächenanderer Gattung bezüglich ihrer gattungsgemäßen Flächenausbildung ebenfalls nicht regelkonform ausgebildet. Durch diese erfindungsgemäße vorteilhafte Ausgestaltung kann eine verbesserte Annäherung an das Berührortauflösungsvermögen des regelmäßigen Musters erreicht werden, aufgrund dessen, dass der Minimalabstand zwischen den nicht regelkonformen Flächen erhalten bleibt.

Bevorzugt ist wenigstens eine zweite, an einer gegenüberliegenden Seite des Durchbruchs angrenzende, Fläche derselben Gattung in Richtung der ersten Fläche nicht regelkonform ausgebildet.

Bevorzugt ist die nicht regelkonforme Fläche bezüglich ihres Außenumfangs bereichsweise nicht deckungsgleich mit dem Außenumfang einer entsprechend regelkonformen Fläche der gleichen Gattung.

Gemäß einer bevorzugten Ausführungsform entspricht der Außenumfang des Durchbruchs im Wesentlichen dem Außenumfang eines Symbols, beispielsweise eines Buchstaben, einer Ziffer oder eines Pfeils, oder auch einer Kombination von mehreren Buchstaben, oder einer Kombination von wenigstens einem Buchstaben mit wenigstens einer Ziffer. Der Durchbruch kann jedoch auch der Form einer Befestigungsvorrichtung oder eines alternativen Bedienelements, wie beispielsweise einem Schaltknopf, entsprechen.

Bevorzugt weist der Durchbruch in der zur Verlaufsrichtung der Spalten oder Reihen orthogonalen Richtung ein maximales lichtes Maß auf, das im Bereich des 0,2 bis 2 fachen, bevorzugt 0,5 bis 1,5-fachen des Spaltenabstandes bzw. Reihenabstandes des regelmäßigen Musters liegt. Der Durchbruch kann gleichzeitig in der verbleibenden senkrechten Richtung aus Spaltenrichtung oder Reihenrichtung, einen über den oben angegebenen Bereich hinausgehendes Ausmaß aufweisen, so ist beispielsweise eine 3- bis 5-fache Größe des Spaltenabstands möglich, wenn der Reihenabstand indem oben definierten Bereich liegt.

Bevorzugt ist die nicht regelkonforme Fläche kleiner als die regelkonforme Fläche der gleichen Gattung. Mögliche Auswirkungen der kleineren Fläche auf die Berührsensitivität, werden beispielsweise durch das in der Auswerteinheit vorgesehenen Auswertverfahren kompensiert. Die bevorzugt softwareseitige Kompensation erfolgt dabei in Abhängigkeit von dem zu kompensierenden Verlust des Auflösungsvermögens der Berührdetektion, insbesondere ist das für die softwareseitige Kompensation verwendete Verfahren durch die Geometrie des Durchbruches bestimmt.

Gemäß einer bevorzugten Ausführungsform ist der geometrische Mittelpunkt des Durchbruchs innerhalb einer durch das regelmäßige Musterdefinierten Spalte und/oder Reihe angeordnet. Der so gekennzeichnete Durchbruch verringert, insbesondere bei Durchbrüchen in dem oben definierten bevorzugten Bereich, die Anzahl der deformierten Flächen, so dass der zu kompensierende Verlust des Auflösungsvermögens der Berührdetektion kleiner ist, und somit eine gleichbleibende Sensitivität in dem Bereich des Durchbruches erreicht werden kann.

Bevorzugt sind die Flächen erster und zweiter Gattung koplanar auf dem Substrat oder bezüglich ihrer Gattungszugehörigkeit auf unterschiedlichen Seiten oder Schichten des Substrats angeordnet.

Das Substrat ist beispielswese ein opakes Substrat. Bevorzugt ist das Substrat eine Leiterplatte.

Eine bevorzugte Ausgestaltung der Anordnung weist einen auf einer zusätzlichen Schicht des Substrats angeordneten elektrischen Leiterzur elektrischen und den Durchbruch umgehenden Verbindung einer der nicht regelkonformen Flächen mit wenigstens einer weiteren Fläche der Senderelektrode oder Empfangselektrode auf, dies ermöglicht unteranderem die Verwirklichung von größeren Durchbrüchen, weiche nicht durch eine nicht regelkonforme Flächenausbildung umgangen werden können.

Die Anordnung weist in einer bevorzugten Ausgestaltung ferner ein über dem Substrat angeordnetes, eine Eingabefläche definierendes Flächengebilde auf, dass in dem zum Durchbruch benachbarten Bereich wenigstens transluzent ausgebildet ist und wobei unter dem Substrat ein Leuchtmittel zur Durchleuchtung des Durchbruchs vorgesehen ist. Durch die erfindungsgemäße Integration von Leuchtmitteln kann insbesondere eine bedienerfreundliche, mit Orientierungshilfen ausgestaltete Bedienfläche gestaltet werden.

Die Orientierungshilfen können zudem durch die erfindungsgemäße Anordnung optimal auf der Bedienfläche platziert werden. Zudem kann eine kompakte Bauweise des Bedienelements erreicht werden. Ein bedienerfreundliches, insbesondere übersichtliches, platzsparendes, Bedienelement ist insbesondere für die Verwendung in einem Fahrzeug von enormem Vorteil. Dieser erfindungsgemäße Vorteil ergibt sich beispielsweise auch dadurch, dass die Konzentration des Fahrzeugführers nicht durch ein unübersichtliches Bedienelement gestört wird.

In einer anderen Ausgestaltung wird der Durchbruch für den Durchgriff eines Befestigungsmittels des Flächengebildes durch das Substratverwendet.

Bevorzugt ist die Anordnung mit einer elektrischen Auswerteinheit ausgestattet, die elektrisch mit den Senderelektroden verbunden ist. Bevorzugt ist die Auswerteeinheit auf der dem Flächengebilde abgewandten Rückseite des Substrates angeordnet, während sich die elektrisch leitenden Flächen erster und zweiter Gattung auf der dem Flächengebilde zugewandten Vorderseite des Substrates befinden.

Die Auswerteinheit ist erfindungsgemäß nach dem Gegenkapazitätsprinzip ausgelegt, mittels der Sende- und Empfangselektroden eine Berührung zu detektieren. Das Gegenkapazitätsprinzip hat insbesondere den Vorteil, dass eine gleichzeitige Mehrfachberührung (Multi-Touch-Berührung) als spezifischeEingabe detektierbar ist.

Bevorzugt ist die Auswerteinheit ausgelegt, das gemessene Signal zwischen einer Empfangselektrode und Sendeelektrode, bei denen wenigstens eine der Elektrodenflächen im sich kreuzenden Bereich der beiden Elektroden eine deformierte Fläche ist, durch einen vorgegebenen Verstärkungsfaktor zu verstärken. Der Verstärkungsfaktor ist dabei insbesondere so ausgelegt das der Verlust des Auflösungsvermögens der Berührdetektion kompensiert wird.

Das Auflösungsvermögen der Berührdetektion kann ferner durch die Verwendung von softwareseitigen Verfahren in dem Bereich des Durchbruchs weiter erhöht werden. So können beispielsweise durch softwareseitige Verstärkungsfaktoren, entstandene Kapazitätsverluste kompensiert werden. Insbesondere bei kleinen Durchbrüchen kann eine Gauß-Filterung, analog zu Weichzeichnern bei der Bildverarbeitung, einen möglichen Verlust des Auflösungsvermögens der Berührdetektion im Bereich der Durchbrüche kompensieren. Eine softwareseitige Kompensation von Durchbrüchen unterschiedlicher Geometrie in einer erfindungsgemäßen Anordnung kann auch durch eine Kombination verschiedenerer softwareseitiger Verfahren, entsprechend der Geometrie des Durchbruches erfolgen.

Die erfindungsgemäße Anordnung ist beispielsweise für eine Verwendung in einem Kraftfahrzeug vorgesehen.

Die Erfindung wird anhand der nachfolgenden Figuren näher erläutert. Die Figuren sind dabei nur beispielhaft zu verstehen.
Fig. 1 zeigt eine Ausführungsform einer aus dem Stand der Technik bekannten regelkonformen Anordnung mit schneeflockenförmigen Flächen erster Gattung.
Fig. 2 zeigt einen vergrößerten Ausschnitt von Fig. 1.
Fig. 3 zeigt in einer schematischen Detailansicht eine Anordnung gemäß Fig. 1 in der Umgebung eines kleineren Durchbruchs.
Fig. 4 zeigt in einer schematischen Detailansicht eine Anordnung gemäß Fig. 1 in der Umgebung eines größeren Durchbruchs.
Fig. 5 zeigt eine Ausführungsform einer aus dem Stand der Technik bekannten regelkonformen Anordnung mit rautenförmigen Flächen.
Fig. 6 zeigt einen vergrößerten Ausschnitt von Fig. 5.
Fig. 7 zeigt eine schematische Ansicht eines Ausführungsbeispiels der vorliegenden Erfindung.

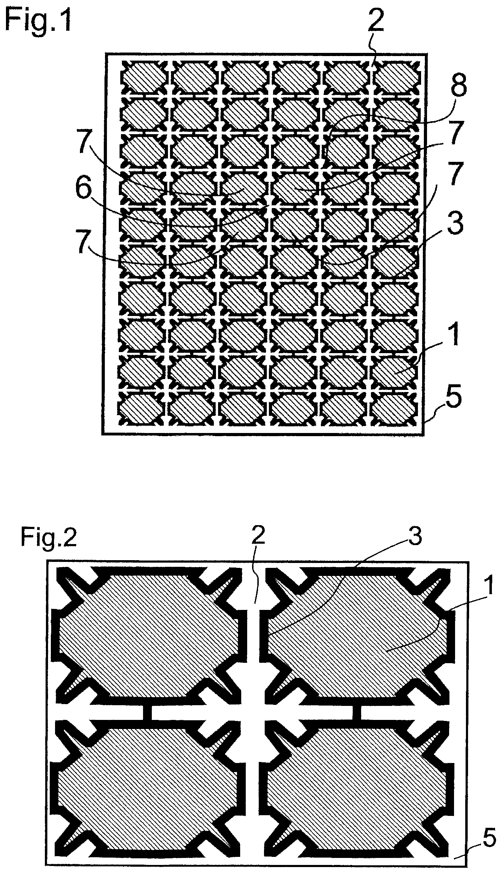

In Fig. 1 ist eine Anordnung von schneeflockenförmigen Flächen zweiter Gattung 2, sowie die mit den schneeflockenförmigen Flächen verwobenen Flächen erster Gattung 1, zur ortsauflösenden projiziert-kapazitiven Berührdetektion auf einem elektrisch isolierenden Substrat 5 zu sehen. Die gezeigten Flächen erster Gattung 1 und zweiter Gattung 2 sind regelkonform angeordnet. In dieser Ausführungsform unterscheiden sich die Flächen der ersten Gattung 1 und zweiten Gattung 2 hinsichtlich ihrer Größe und Form. So sind beispielsweise die Flächen der ersten Gattung 1 größer als die Flächen der zweiten Gattung 2, zudem sind die Flächen der ersten Gattung 1 mit den Flächen der zweiten Gattung 2 verwoben, so dass beispielsweise durch jeweils vier nächstliegende Flächen 7 der ersten Gattung 1 eine Fläche 6 der zweiten Gattung 2 vorgegeben ist. Die Flächen der ersten Gattung 1 sind auf einer tieferliegenden Schicht des Substrats 5, unterhalb der Flächen zweiter Gattung 2 angeordnet, die reihenweise Verbindung zwischen den Flächen erster Gattung 1 ist durch einen schraffierten Bereich hervorgehoben. Die so angeordneten Flächenerster Gattungen 1 bilden insgesamt zehn Senderelektroden. Die Flächen zweiter Gattung 2 sind spaltenweise verbunden und bilden insgesamt sechs Empfangselektroden. Für die projiziert-kapazitive Berührdetektion wird ein elektrisches Feld bzw. eine Kapazität zwischen den Flächen der ersten Gattung 1 und zweiten Gattung 2 aufgebaut. Die hier gezeigten Flächen erster Gattung 1 und zweiter Gattung 2 sind so ausgebildet, dass die gemeinsame Grenzfläche maximal ist.

Durch eine maximierte Grenzfläche zwischen den Flächen, Elektroden, erster Gattung 1 und zweiter Gattung 2 wird die Kapazität zwischen den Flächen, Elektroden, erster Gattung 1 und zweiter Gattung 2 maximiert. Zudem ist, in dem hier gezeigten gleichmäßigen Muster der Abstand der Flächen erster Gattung 1 und zweiter Gattung 2 ein Minimalabstand 3. Durch die verwobene Ausgestaltung der Flächen erster Gattung 1 mit den Flächen zweiter Gattung 2 erreichen die ladungstragenden Flächen eine maximale Abdeckung der auf dem Substrat 5zur Verfügung stehenden Fläche. Im Allgemeinen gilt, dass die Kapazität umgekehrt proportional zu dem Abstand zwischen den ladungstragenden Flächen, Elektroden, erster Gattung 1 und zweiter Gattung 2 ist.

Da der Abstand zwischen den Flächen ein Minimalabstand 3 ist, ist die Kapazität bezüglich des Abstandes maximiert. Der Minimalabstand 3 ist in der in Fig. 1 - Fig.4 dargestellten Ausführungsform durch eine schwarze Linie dargestellt. Die schwarze Linie kennzeichnet gleichzeitig auch die gemeinsame Grenzfläche. Besonders deutlich ist der Minimalabstand 3 in der schematischen Detailansicht in Fig.2 zu erkennen.

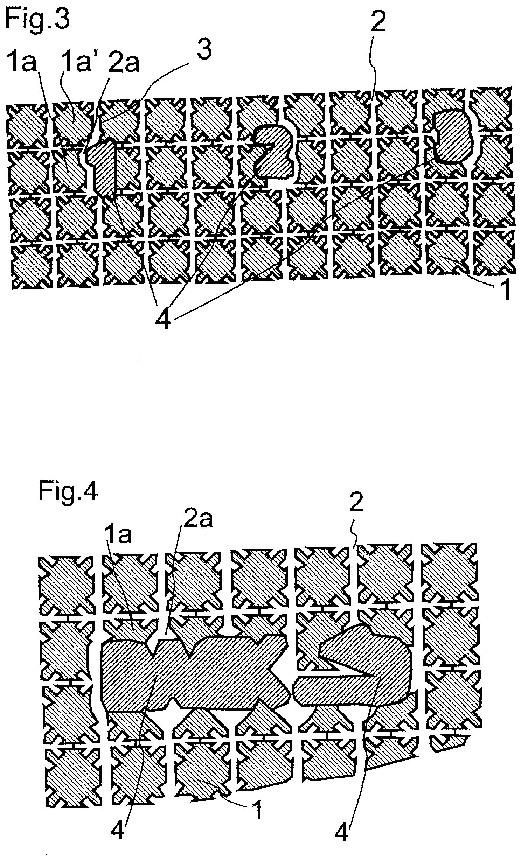

In Fig.3 ist eine schematische Detailansicht, einer Anordnung mit teilweise nicht regelkonformer schneeflockenförmiger Flächenausbildung zweiter Gattung 2 und entsprechender Flächen erster Gattung 1 in der Umgebung eines Durchbruchs 4 zu sehen. Die hier gezeigten Durchbrüche 4weisen ein maximales lichtes Maß auf und haben die Form der Ziffern 1,2 oder 3. Der jeweilige Durchbruch 4 hat etwa die 1-fache Größe des Spalten-bzw. Reihenabstandes des regelmäßigen Musters. Angrenzend an den Durchbruch sind Flächen der zweiten Gattung 2a vorgesehen, die bezüglich ihrer Flächenausbildung nicht regelkonform ausgestaltet sind, wobei der vorgegebene Minimalabstand 3 zu drei nächstbenachbarten Flächen der anderen Gattung erreicht wird.

Es ist zu sehen, dass alle drei (1a, 1a') zur nicht regelkonformen ersten Fläche 2a nächstbenachbarten Flächen, bezüglich ihrer Flächenausbildung ebenfalls nicht regelkonform ausgebildet sind. Die nicht regelkonforme Ausgestaltung der nächstbenachbarten Flächen ermöglicht beispielsweise die Einhaltung des Minimalabstandes 3, die Maximierung der gemeinsamen Grenzflächen zwischen der jeweiligen Fläche 1a, 1 a' und der Fläche 2a und/oder die Vergrößerung der ladungstragenden Fläche. Somit verändert sich beispielsweise die Kapazität zwischen der direkt am Durchbruch 4 angrenzenden Fläche 2a und der jeweiligen Fläche 1a, 1a' bezüglich der veränderten gemeinsamen Grenzfläche und der Ladungsmengeauf der ladungstragenden Fläche, nicht aber bezüglich des Minimalabstandes 3.

Verglichen mit der gemeinsamen Grenzfläche der regelkonformen Flächen (Fig.1 und Fig. 2), ist die gemeinsame Grenzfläche der nichtregelkonformen Flächen verringert. Um die Verringerung der gemeinsamen Grenzfläche der nicht regelkonformen Flächen erster Gattung 1 und zweiter Gattung 2 zu minimieren werden die Flächen von einem vormals gradlinigen Verlauf in einen gekrümmten Verlauf deformiert. Der gekrümmte Verlauf ist aus der Perspektive des Durchbruchs 4 beispielsweise konvex gekrümmt, beispielsweise liegt der Krümmungsmittelpunkt 9 innerhalb des Durchbruches 4. Beispielsweise kann durch die Vergrößerung der ladungstragenden Fläche der, durch die Verringerung der gemeinsamen Grenzfläche, entstandene Kapazitätsverlust kompensiert werden. Es ist zu beachten, dass die Verringerung der gemeinsamen Grenzfläche unterschiedlich zwischen den jeweiligen nicht regelkonformen Flächen ausfallen kann. So ist beispielsweise die gemeinsame Grenzfläche der Flächen 1a' und 2a größer als die gemeinsame Grenzfläche der Flächen 1a und 2a. Gleichzeitig gilt, dass beispielsweise die ladungstragende Fläche 2a im Bereich der gemeinsamen Grenzfläche 1a' zu 2a kleiner als die ladungstragende Fläche 2a im Bereich der gemeinsamen Grenzfläche 1a zu 2a ist. Somit wird durch die Maximierung der gemeinsamen Grenzflächen, unter Berücksichtigung der Größe der ladungstragenden Fläche und damit der Ladungsmenge, der durch die Abweichung von dem regelmäßigen Muster entstandene Kapazitätsverlust minimiert. Dieser minimierte Kapazitätsverlust, kann zudem beispielsweise softwareseitig kompensiert werden. Beispielswiese kann durch einen softwareseitigen Verstärkungsfaktor, in der in den Figuren nicht gezeigten Auswerteeinheit, beispielsweise entsprechend der verkleinerten gemeinsamen Grenzfläche unter Berücksichtigung der, der ladungstragenden Fläche entsprechenden, Ladungsmenge der Kapazitätsverlust an den nicht regelkonformen Flächenkompensiert werden.

Desweiteren kann in der Umgebung eines Durchbruches 4 beispielsweise die Kapazität durch Vergrößerung der gemeinsamen Grenzfläche und der ladungstragenden Fläche entsprechenden Ladungsmenge, zwischen den Flächen 1b, sowie 1b erhöht werden. Eine solche Erhöhung der Kapazität hat beispielsweise zur Folge, dass die Sensitivität der Berührdetektion an der entsprechenden Grenzfläche erhöht wird. Dies kann beispielsweise die fehlende gemeinsame Grenzfläche zwischen den Flächen 2a und 1b und damit auch die fehlende Kapazität kompensieren.

In Fig. 4 ist eine schematische Detailansicht, einer Anordnung mit teilweise nicht regelkonformer schneeflockenförmiger Flächenausbildung zweiter Gattung 2 und entsprechender Flächen erster Gattung 1 in der Umgebung eines Durchbruchs 4 zu sehen. Die hier gezeigten Durchbrüche4 weisen ein maximales lichtes Maß auf, und entsprechen einer Kombination von Buchstaben zu dem Wort "Back", sowie einem gebogenen Pfeil. Der jeweilige Durchbruch 4 hat etwa die 1-fache Größe des Reihenabstandes des regelmäßigen Musters, jedoch insgesamt etwa eine 5-fache Größe des Spaltenabstandes. Angrenzend an den Durchbruch 4 sind Flächen der ersten Gattung 1b oder zweiten Gattung 2a vorgesehen, die bezüglich ihrer gattungsgemäßen Flächenausbildung nicht regelkonform ausgestattet sind, wobei der vorgegebene Minimalabstand 3 zu jeweils wenigstens zwei nächstbenachbarten Flächen (1a, 1a') der anderen Gattung erreicht wird. Bei dem hier gezeigten größeren Durchbruch 4 ist es nicht möglich alle Empfangselektroden durch eine nicht regelkonforme Flächenausbildung mit der jeweiligen, durch den Durchbruch 4, getrennten Empfangselektroden zu verbinden, die jeweiligen Empfangselektroden wurden deshalb über eine abgeschirmte Lage der Leiterplatte miteinander elektrisch verbunden. Die Mittellinie des hier gezeigten größeren Durchbruchs 4 liegt in etwa auf der Verbindungslinie zwischen den geometrischen Mittelpunkten der Flächenzweiter Gattung 2. Durch den so positionierten größeren Durchbruch 4 können die Flächen erster Gattung 1, durch nicht regelkonforme Ausgestaltungmiteinander verbunden werden, zudem müssen so nur die zu dem größeren Durchbruch 4 hingewandten Flächenseiten deformiert werden.

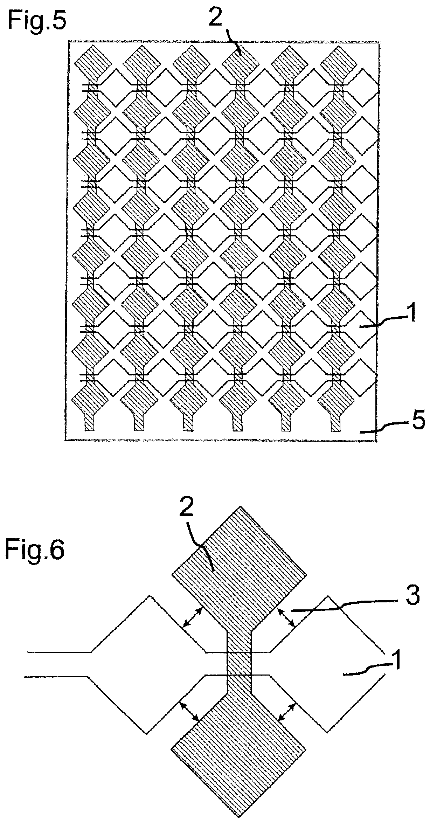

In Fig.5 ist eine bevorzugte Anordnung von rautenförmigen Flächen zur ortsauflösenden projiziert-kapazitiven Berührdetektion auf einemelektrisch isolierenden Substrat 5 zu sehen. Die gezeigten rautenförmigen Flächen sind regelkonform und gattungsweise alternierend angeordnet. So sind die Flächen erster Gattung 1 reihenweise untereinander elektrisch verbunden, um mehrere Senderelektroden auszubilden und die Flächenzweiter Gattung 2 sind spaltenweise untereinander elektrisch verbunden, um mehrere Empfangselektroden auszubilden. Durch diese gattungsweisealternierende Anordnung wird ein im Wesentlichen regelmäßiges Muster ausgebildet. Der Minimalabstand 3 ist dabei als der Abstand zwischen der jeweiligen nächsten Längsseite der benachbarten Flächen erster Gattung 1 und zweiter 2 Gattung zu verstehen.

In Fig.6 ist der Minimalabstand 3 durch Abstandspfeile dargestellt. In der in Fig.5 und Fig.6 gezeigten regelkonformen Anordnung ist sowohl der Minimalabstand 3 zwischen allen Flächen, als auch der Abstand zwischen den geometrischen Mittelpunkten der jeweiligen Flächen ist erhalten. Zudem sind die Flächen erster Gattung 1 und zweiter Gattung 2 nicht deformiert. In dieser Ausführungsform unterscheiden sich die Flächen der ersten Gattung 1 und zweiten Gattung 2 nicht hinsichtlich ihrer Größe und Form. Die Flächen der ersten Gattung 1 sind auf einer tieferliegenden Schicht des Substrats 5, unterhalb der Flächen zweiter Gattung 2 angeordnet.

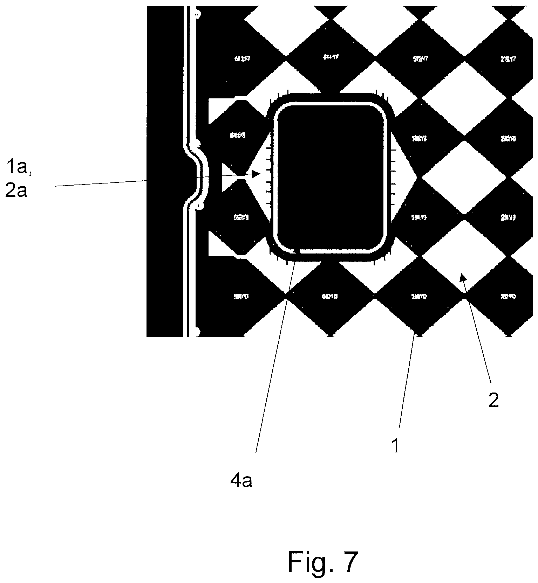

Fig. 7 zeigt ein Ausführungsbeispiel der Erfindung. Dargestellt ist ein Bereich 4a der oberhalb einem lichtdurchlässigen Substrat 5 angeordnet ist, so dass ein Durchbruch 4, wie im Stand der Technik so nicht mehr notwendig ist.

## Patentansprüche

1. Anordnung zur ortsauflösenden projiziert-kapazitiven Berührdetektion aufweisend ein elektrisch isolierendes Substrat (5), mit mehreren auf dem Substrat nebeneinander angeordneten elektrisch leitenden Flächen erster Gattung (1) und zweiter Gattung (2), wobei die Flächen innerhalb einer Gattung regelmäßig eine gleichförmige Flächenausbildung aufweisen, und wobei die Flächen erster Gattung (1) untereinander elektrisch verbunden sind, um mehrere Senderelektroden auszubilden und die Flächen zweiter Gattung (2) elektrisch verbunden sind, um mehrere Empfangselektroden auszubilden, und im Wesentlichen ein regelmäßiges Muster aufgrund ihrer gattungsgemäßen regelkonformen Flächenausbildung und Platzierung ausbildend angeordnet sind, wobei in dem Substrat (5) ein Bereich (4) ausgebildet ist, wobei die Empfangselektroden spaltenweise und die Sendeelektroden reihenweise miteinander verbunden sind, dass die Flächen erster Gattung (1) und die Flächen zweiter Gattung (2) alternierend angeordnet sind, dass die Fläche der einen Gattung (6) von mehreren Flächen der anderen Gattung (7) jeweils einen Minimalabstand (3) einhaltend umgeben ist, und dass wenigstens eine an den Bereich (4) angrenzende erste Fläche (1b, 2a) der ersten Gattung (1) oder zweiten Gattung (2) vorgesehen ist, die bezüglich ihrer gattungsgemäßen Flächenausbildung und/oder Platzierung nicht regelkonform so ausgestaltet ist, dass der vorgegebene Minimalabstand (3) zu jeweils wenigstens zwei nächstbenachbarten Flächen (1a, 1a') der anderen Gattung erreicht wird, **dadurch gekennzeichnet, dass** ein Bereich 4a oberhalb einem lichtdurchlässigen Substrat 5 oder einem Bereich im Substrat 5 angeordnet ist, welches lichtdurchlässig ist.

2. Anordnung gemäß Anspruch 1, wobei ferner wenigstens eine der zwei (1a, 1a') zur nicht regelkonformen ersten Fläche (1b, 2a) nächstbenachbarten Flächen anderer Gattung bezüglich ihrer gattungsgemäßen Flächenausbildung ebenfalls nicht regelkonform ausgebildet ist.

3. Anordnung gemäß einem der beiden vorhergehenden Ansprüche, wobei die nicht regelkonforme Fläche (1b,2a) einen Außenumfang aufweist, der bereichsweise nicht deckungsgleich mit dem Außenumfang einer entsprechend gattungsgemäßen regelkonformen Fläche (1,2) ist.

4. Anordnung gemäß einem der vorhergehenden Ansprüche, wobei der Außenumfang des Bereichs (4) im Wesentlichen dem Außenumfang eines Symbols entspricht.

5. Anordnung gemäß einem der vorhergehenden Ansprüche, wobei der Bereich (4) in der zur Verlaufsrichtung der Spalten oder Reihen orthogonalen Richtung ein maximales lichtes Maß aufweist, das im Bereich des 0,2 bis 2-fachen, bevorzugt 0,5 bis 1,5-fachen des Spaltenabstandes bzw. Reihenabstandes des regelmäßigen Musters liegt.

6. Anordnung gemäß einem der vorhergehenden Ansprüche, wobei die nicht regelkonforme Fläche (1b, 2a) kleiner ist als die gattungsgemäße regelkonforme Fläche (1,2).

7. Anordnung gemäß einem der vorhergehenden Ansprüche, wobei der geometrische Mittelpunkt des Bereichs (4) innerhalb einer durch das regelmäßige Muster definierten Spalte und/oder Reihe angeordnet ist.

8. Anordnung gemäß einem der vorhergehenden Ansprüche, wobei die Flächen erster Gattung (1) und zweiter Gattung (2) koplanar auf dem Substrat (5) oder bezüglich ihrer Gattungszugehörigkeit auf unterschiedlichen Seiten oder Schichten des Substrats (5) angeordnet sind.

9. Anordnung gemäß einem der vorhergehenden Ansprüche, wobei das Substrat (5) eine Leiterplatte ist.

10. Anordnung gemäß einem der vorhergehenden Ansprüche, ferner aufweisend einen auf einer zusätzlichen Schicht des Substrats (5) angeordneten elektrischen Leiter zur elektrischen und den Bereich (4) umgehenden Verbindung einer der nicht regelkonformen Flächen mit wenigstens einer weiteren Fläche der Senderelektrode oder Empfangselektrode.
